# EUROPÄISCHE PATENTSCHRIFT

(11) **EP 2 559 061 B1**
(45) Veröffentlichungstag und Bekanntmachung des Hinweises auf die Patenterteilung: **25.07.2018**
(21) Anmeldenummer: 11741401.1
(22) Anmeldetag: 13.04.2011
(51) Int. Cl.: H01L 21/60, H01L 21/67, B23K 1/005, B23K 3/06

(54) **VERFAHREN ZUR AUSBILDUNG VON LOTDEPOTS AUF ERHÖHTEN KONTAKTMETALLISIERUNGEN EINES SUBSTRATS**
METHOD FOR FORMING SOLDER DEPOSITS ON PROTRUDING CONTACTS OF A SUBSTRATE
PROCÉDÉ POUR FORMER DES DÉPÔTS DE BRASURE SUR DES CONTACTS SAILLANTS D'UN SUBSTRAT

(30) Priorität: 16.04.2010 DE 102010015520
(43) Veröffentlichungstag der Anmeldung: 20.02.2013
(73) Patentinhaber: Pac Tech - Packaging Technologies GmbH, 14641 Nauen (DE)
(72) Erfinder: AZDASHT, Ghassem, 13591 Berlin (DE)
(74) Vertreter: advotec.
(86) Internationale Anmeldenummer: PCT/DE2011/000394
(87) Internationale Veröffentlichungsnummer: WO 2011/127907

(56) Entgegenhaltungen:
- JP-A- 6 021 147
- JP-A- 8 203 904
- JP-A- 8 222 572
- JP-A- 9 275 107
- JP-A- H0 774 178
- JP-A- H0 774 178
- JP-A- H08 222 843
- JP-A- H08 222 843
- JP-A- 2000 150 555
- JP-A- 2000 150 555
- JP-A- 2000 349 110
- JP-A- 2000 349 110
- JP-A- 2008 034 756
- US-A- 6 136 047
- US-A1- 2002 142 516
- US-A1- 2008 206 587
- US-A1- 2010 105 173
- FON BIH WEN ET AL: "Lead-free Solder Paste Selection and Solder Joint Reliability for Copper Stud Flip Chip", 2008 INTERNATIONAL CONFERENCE ON ELECTRONIC MATERIALS AND PACKAGING (EMAP 2008); TAIPEI, TAIWAN, 22-24 OCTOBER 2008; [IN CONJUNCTION WITH THE 3RD INTERNATIONAL MICROSYSTEMS, PACKAGING, ASSEMBLY AND CIRCUITS TECHNOLOGY CONFERENCE (IMPACT)]; IEEE, 22. Oktober 2008 (2008-10-22), Seiten 80-83, XP031425302, ISBN: 978-1-4244-3620-0
- "Lotpaste", Wikipedia, 23. Februar 2010 (2010-02-23), XP055017305, Gefunden im Internet: URL:http://de.wikipedia.org/w/index.php?ti tle=Lotpaste&oldid=71070639 [gefunden am 2012-01-23]

## Beschreibung

Die vorliegende Erfindung betrifft ein Verfahren zur Ausbildung von Lotdepots auf erhöhten Kontaktmetallisierungen von Anschlussflächen eines insbesondere als Halbleiterbauelement ausgebildeten Substrats, bei dem Benetzungsoberflächen der Kontaktmetallisierungen in Berührungskontakt mit einer auf einem Lotmaterialträger angeordneten Lotmaterialschicht gebracht werden, zumindest während der Dauer des Berührungskontakts eine Beheizung der Kontaktmetallisierungen des Substrats und eine Temperierung der Lotmaterialschicht erfolgt, und nachfolgend eine Trennung des Berührungskontakts zwischen den mit Lotmaterial benetzten Kontaktmetallisierungen und der Lotmaterialschicht erfolgt.

Insbesondere zur Kontaktierung von Halbleiterbauelementen, wie beispielsweise Chips im sogenannten "Flip-Chip-Verfahren", bei dem die Halbleiterbauelemente mit ihren Anschlussflächen unmittelbar mit Anschlussflächen von Kontaktsubstraten kontaktiert werden, werden die Halbleiterbauelemente regelmäßig mit erhöhten Kontaktmetallisierungen (Bumps) versehen, die auf ihrer Oberfläche ein Lotdepot aufweisen, um durch Aufschmelzen der Lotdepots eine elektrisch leitende und mechanisch haltbare Verbindung der Halbleiterbauelemente mit den Kontaktsubstraten herzustellen. Die Kontaktmetallisierungen sorgen dabei für eine exponierte Anordnung der durch die Lotdepots definierten Verbindungsstellen.

Die Erzeugung bzw. Aufbringung von Lotdepots auf den Kontaktmetallisierungen kann auf unterschiedliche Art und Weise erfolgen. Beispielsweise ist es bekannt, Lotdepots galvanisch aufzubringen, wobei die Anwendung dieses Verfahrens eine entsprechende Maskierung der Oberfläche des Halbleiterbauelements voraussetzt, so dass sich das bekannte Verfahren durch einen entsprechenden Aufwand auszeichnet. Ebenfalls ist es bekannt, Lotdepots auf erhöhte Kontaktmetallisierungen durch "Sputtern" aufzubringen, wobei dieses Verfahren ebenfalls eine aufwendige Maskierung der Oberfläche des Halbleiterbauelements voraussetzt.

Demgegenüber als weniger aufwendig erweist sich ein Verfahren, bei dem die Kontaktmetallisierungen mit ihren Benetzungsoberflächen in aufgeschmolzenes Lotmaterial eingetaucht werden, das nach Entfernung der Kontaktmetallisierungen aus dem Lotmaterialbad durch Erstarrung die beabsichtigten Lotmaterialdepots ausbildet.

Als problematisch erweist sich die Durchführung dieses an sich kostengünstigen Verfahrens jedoch dann, wenn solche Halbleiterbauelemente mit Lotdepots ausgestattet werden sollen, deren Anschlussflächenverteilung einen besonders feinen "Pitch" aufweist, so dass die einzelnen Anschlussflächen bzw. die auf den Anschlussflächen ausgebildeten Kontaktmetallisierungen einen nur sehr geringen Abstand voneinander aufweisen. Diese Abstände zwischen den Kontaktmetallisierungen liegen häufig in der Größenordnung von 10 µm. Bei diesem geringen Abstand kann es aufgrund der Oberflächenspannung des aufgeschmolzenen Lotmaterials zur Ausbildung von Kontaktbrücken zwischen den Lotdepots benachbarter Kontaktmetallisierungen kommen. Da dies im Betrieb der Halbleiterbauelemente zwangsläufig zu einem Bauteilversagen führt, müssen Halbleiterbauelemente, die derartige Kontaktfehler aufweisen, im Rahmen der Qualitätssicherung als Ausschuss aus der Produktion entfernt werden. Hierdurch können erhebliche wirtschaftliche Verluste entstehen.

Die JP H07 74178 A, JP H06 21147 A, US 2002/0142516 A1 sowie JP H08 222572 A beschreiben ein Verfahren zum Anordnen von Lotmittel auf elektrischen Bauelementen, wobei eine Haltevorrichtung mittels Unterdruck ein Flip-Chip-Bauelement festhält und eine Heizvorrichtung der Haltevorrichtung ermöglicht, dass eine auf einem Lotmaterialträger angeordnete Lotmittelschicht bei Berührung mit dem Bauelement aufgeschmolzen wird und sich Lotmittel auf Kontaktflächen des Bauelements anordnet. Die Lehre von JP H08 203904 A ist ähnlich, wobei jedoch kein Lotmaterialträger verwendet wird.

Die JP 2008 034756 A, JP H09 275107 A sowie US 6136047 sehen eine dahingehende Abwandlung vor, dass das Lotmittel, mit dem das Bauelement zumindest bereichsweise in Kontakt gebracht wird, nicht als Schicht, sondern als individuelle Punkte oder vereinzelte Mengen angeordnet ist.

Aus der oben genannten JP H07 74178 A ist zusätzlich bekannt, eine Maske auf der Lotmittelschicht zu verwenden, um unerwünschte Lotbrücken zwischen benachbarten Kontaktmetallisierungen zu vermeiden.

Die JP 2000 349110 A beschreibt ein Verfahren zur Ausbildung von Lotdepots auf Kontaktmetallisierungen eines Substrats, bei dem das Lotmaterial in Form von passend beabstandeten, vorbereiteten Erhebungen auf einem Träger angeordnet ist und eine Kühlung zur Trägertemperaturkontrolle vorgesehen ist. Aus der JP H08 222843 A ist ein Verfahren zur Ausbildung von Lotdepots auf Kontaktmetallisierungen eines Substrats bekannt, bei dem eine Negativform verwendet wird, welche vorgeformte und passend beabstandete Mengen von Lotmaterial bereitstellt. Eine als Kühlwasserdurchfluss ausgebildete Temperiereinrichtung ist in einem unter einem Lotmaterialträger angeordneten Heizblock vorgesehen. Die JP 2000 150555 A offenbart ein Verfahren zur Ausbildung von Leitkleberdepots auf Kontaktmetallisierungen eines Substrats, bei dem die Kontaktmetallisierungen in eine Schicht aus dem Leitkleber getaucht werden, die auf einem Träger angeordnet ist, der von einer durch Wasserdurchfluss kühlbaren Trägerplattform gehalten wird.

Der vorliegenden Erfindung liegt daher die Aufgabe zugrunde, ein Verfahren vorzuschlagen, das bzw. die eine Ausbildung von Lotdepots auf erhöhten Kontaktmetallisierungen von Anschlussflächen eines Substrats mit verringertem Ausschussrisiko ermöglicht.

Diese Aufgabe wird durch ein Verfahren mit den Merkmalen des Anspruchs 1 gelöst.

Bei dem erfindungsgemäßen Verfahren werden Benetzungsoberflächen der Kontaktmetallisierungen des Substrats in Berührungskontakt mit einer auf einem Lotmaterialträger angeordneten Lotmaterialschicht gebracht, wobei zumindest während der Dauer des Berührungskontakts eine Beheizung der Kontaktmetallisierungen des Substrats und eine Temperierung der Lotmaterialschicht erfolgt, und nachfolgend eine Trennung des Berührungskontakts zwischen den mit Lotmaterial benetzten Kontaktmetallisierungen und der Lotmaterialschicht erfolgt.

Aufgrund der erfindungsgemäßen Temperierung der Lotmaterialschicht während der Beheizung der Kontaktmetallisierungen wird verhindert, dass es durch die Beheizung der Kontaktmetallisierungen zu einem vollständigen Aufschmelzen der Lotmaterialschicht kommt. Stattdessen kommt es lediglich in diskreten, lokal begrenzten, durch die Benetzungsoberflächen definierten Bereichen der Lotmaterialschicht zu einem Aufschmelzen mit entsprechender Benetzung der Benetzungsoberflächen. Zwischen den Benetzungsoberflächen der Kontaktmetallisierungen verbleiben Bereiche in der Lotmaterialschicht, welche abweichend von den Bereichen der Lotmaterialschicht, die den Benetzungsoberflächen der Kontaktmetallisierungen gegenüberliegen, nicht aufgeschmolzen sind.

Damit wird verhindert, dass es bei einer Trennung des Berührungskontakts zwischen den Benetzungsoberflächen der Kontaktmetallisierungen und der Lotmaterialschicht aufgrund der Oberflächenspannung von aufgeschmolzenem Lotmaterial zur Ausbildung von Kontaktbrücken zwischen benachbarten Kontaktmetallisierungen kommt. Vielmehr werden durch das diskrete bzw. partielle Aufschmelzen der Lotmaterialschicht die aufgeschmolzenen Bereiche aus der Lotmaterialschicht aufgrund der Benetzungskräfte herausgelöst, und die nicht aufgeschmolzenen Bereiche der Lotmaterialschicht verbleiben auf dem Lotmaterialschichtträger.

Als besonders vorteilhaft erweist es sich, wenn während der Ausbildung des Berührungskontakts der Lotmaterialschicht zumindest die Kontaktmetallisierungen in einer Schutzmediumatmosphäre angeordnet sind, um eine Oxidation der Kontaktmetallisierungen bzw. der Benetzungsoberflächen der Kontaktmetallisierungen zu verhindern.

Wenn die Ausbildung der Schutzmediumatmosphäre durch den Auftrag einer Flussmittelschicht auf die Lotmaterialschicht erfolgt, ist die Ausbildung der Schutzmediumatmosphäre mit geringstmöglichem Aufwand möglich.

Besonders vorteilhaft hinsichtlich einer der Ausbildung von Lotdepots auf den Kontaktmetallisierungen unmittelbar nachfolgenden Kontaktierung des Halbleiterbauelements mit einem Kontaktsubstrat ist es, wenn die Kontaktierung der Kontaktmetallisierungen mit der Lotmaterialschicht und die Trennung der Kontaktmetallisierungen von der Lotmaterialschicht vermittels einer Zustell- bzw. Rückstellbewegung des Substrats erfolgt, da die Rückstellbewegung des Substrats gleichzeitig genutzt werden kann, um das Substrat in eine gewünschte Relativposition zu einem Kontaktsubstrat für eine nachfolgende Kontaktierung zu verbringen.

Besonders vorteilhaft ist es auch, wenn das Substrat zur Ausführung der Zustell- bzw. Rückstellbewegung in einer Handhabungseinrichtung aufgenommen ist, die gleichzeitig zur Beaufschlagung des Substrats mit Laserenergie dient, so dass ein und dieselbe Handhabungseinrichtung sowohl zur Ausbildung der Lotdepots auf den Kontaktmetallisierungen als auch für eine nachfolgende Kontaktierung des mit den Lotdepots versehenen Substrats mit einem Kontaktsubstrat verwendet werden kann. Hierbei kann dieselbe Beheizungseinrichtung, insbesondere die Lasereinrichtung, die zur Ausbildung der Lotdepots dient, auch zur Durchführung des Kontaktierungsvorgangs dienen. Darüber hinaus ist es möglich, die Lotdepots unmittelbar nach Ausbildung im aufgeschmolzenen Zustand zu belassen, um somit eine nachfolgende Kontaktierung ohne ein erneutes Aufschmelzen der Lotdepots energieeffizient durchführen zu können. Wenn die Temperierung der Lotmaterialschicht vermittels einer den Lotmaterialträger aufnehmenden temperierbaren Trägerplattform erfolgt, ist es möglich, den Lotmaterialträger einerseits und die Trägerplattform andererseits hinsichtlich ihrer unterschiedlichen Funktionen zu optimieren, anstatt, wie es beispielsweise der Fall wäre, wenn der Lotmaterialträger gleichzeitig zur Temperierung dienen sollte, den Lotmaterialträger so auszubilden, dass neben der Bereitstellungsfunktion für die Lotmaterialschicht auch die Temperierfunktion gewährleistet ist. Abweichend hiervon ist es natürlich jedoch auch in einem Beispiel, das zum Verständnis der Erfindung beiträgt, denkbar, eine Trägerplattform auszubilden, die einerseits temperierbar ist und andererseits über eine besondere Oberfläche bzw. Oberflächenbeschichtung verfügt, die sich vorteilhaft auf die Bereitstellung der Lotmaterialschicht auswirkt.

Zur Ausbildung der Lotmaterialschicht kann der Lotmaterialträger mit einer Schicht aus einem fluiden oder pastösen Lotmaterial oder auch aus Lotmaterialformkörpern gebildet sein, wobei insbesondere in letzterem Fall es besonders vorteilhaft ist, wenn die Lotmaterialformkörper einen Durchmesser aufweisen, der kleiner ist als der Abstand zwischen den Kontaktmetallisierungen des Substrats, um zu verhindern, dass es durch einen gleichzeitigen Kontakt zwischen einem Lotmaterialformkörper und zwei benachbarten Kontaktmetallisierungen zur Ausbildung einer Kontaktbrücke kommen kann.

Eine Vorrichtung zur Durchführung des erfindungsgemäßen Verfahrens weist eine Aufnahmeeinrichtung zur Aufnahme des Substrats, eine Beheizungseinrichtung zur Beheizung des Substrats und eine Trägerplattform zur Bereitstellung einer auf einem Lotmaterialträger angeordneten Lotmaterialschicht auf, wobei die Trägerplattform mit einer Temperiereinrichtung zur Temperierung der Lotmaterialschicht versehen ist und mit einer Zustelleinrichtung, die zur Ausführung einer Zustell- bzw. Rückstellbewegung dient, derart, dass die Herstellung eines Berührungskontakts zwischen erhöhten Kontaktmetallisierungen des Substrats und der Lotmaterialschicht mit nachfolgender Trennung des Berührungskontakts ermöglicht wird.

Besonders vorteilhaft ist es, wenn die Aufnahmeeinrichtung durch eine Handhabungseinrichtung gebildet ist, die mit einer Lasereinrichtung zur Beaufschlagung des Substrats mit Laserenergie versehen ist.

Zur Ausführung der Zustell- bzw. Rückstellbewegung kann die Handhabungseinrichtung dienen, jedoch ist es auch besonders vorteilhaft, wenn die Trägerplattform zur Ausführung der Zustell- und Rückstellbewegung mit einer Zustelleinrichtung versehen ist.

Eine besonders kompakte Ausbildung der Vorrichtung wird möglich, da die Trägerplattform gleichzeitig als Temperiereinrichtung gemäß Anspruch 1 ausgebildet ist. Hinsichtlich eines modularen Aufbaus der Vorrichtung erweist es sich in einem Beispiel, das zum Verständnis der Erfindung beiträgt, als vorteilhaft, wenn die Temperiereinrichtung unabhängig von der Trägerplattform ausgebildet ist, da somit grundsätzlich auch die Möglichkeit besteht, unterschiedliche Temperiereinrichtungen mit ein und derselben Trägerplattform zu kombinieren.

Nachfolgend werden eine bevorzugte Variante des erfindungsgemäßen Verfahrens sowie eine bei Ausführung des Verfahrens zum Einsatz kommende Vorrichtung anhand der Zeichnungen näher erläutert.

Es zeigen:
- **Fig. 1**: eine Lotdepoterzeugungsvorrichtung in einer Zustellphase;
- **Fig. 2**: die Lotdepoterzeugungsvorrichtung in einer Benetzungsphase;
- **Fig. 3**: die Lotdepoterzeugungsvorrichtung in einer Erstarrungsphase.

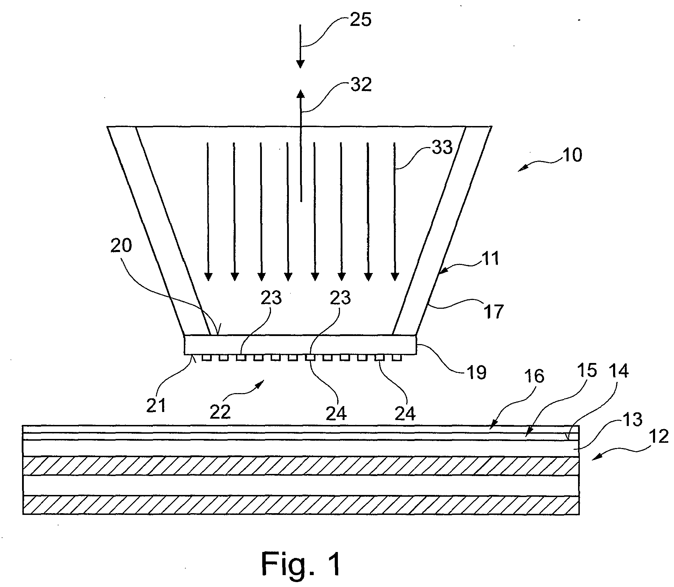

**Fig. 1** zeigt eine Lotdepoterzeugungsvorrichtung 10 mit einer Handhabungseinrichtung 11 und einer unterhalb der Handhabungseinrichtung 11 angeordneten Trägerplattform 12, die zur Aufnahme eines Lotmaterialträgers 13 dient, auf dessen Oberfläche 14 eine Lotmaterialschicht 15 angeordnet ist, die im Fall des in **Fig. 1** dargestellten Ausführungsbeispiels aus einer pastösen Lotmaterialmasse gebildet ist.

Die Lotmaterialschicht 15 ist im vorliegenden Fall zur Abschirmung gegen die Umgebung von einer Flussmittelschicht 16 abgedeckt.

Die Handhabungseinrichtung 11 weist ein unteres, als Aufnahmeeinrichtung 17 ausgebildetes Mundstück auf, mit einer durch einen rahmenartigen Öffnungsrand ausgebildeten Anlagefläche 18, die zur Abstützung eines durch Einwirkung von Unterdruck am Mundstück 17 gehaltenen, hier als Halbleiterbauelement ausgebildeten Substrats 19 dient. Zur Erzeugung des Unterdrucks ist die Handhabungseinrichtung 11 mit einer hier nicht näher dargestellten Unterdruckeinrichtung versehen, die eine entsprechende Unterdruckkraft 32 auf eine Rückseite 20 des Halbleiterbauelements ausübt, derart, dass die Rückseite 20 gegen die Anlagefläche 18 fixiert anliegt.

Bei dem in **Fig. 1** dargestellten Ausführungsbeispiel handelt es sich bei dem Halbleiterbauelement 19 um einen Chip, der auf seiner der Rückseite 20 gegenüberliegenden Kontaktseite 21 mit einer Anschlussflächenverteilung 22 versehen ist, auf deren einzelnen Anschlussflächen 23 jeweils eine erhöhte, fachterminologisch auch als Bump bezeichnete Kontaktmetallisierung 24 ausgebildet ist.

Die in **Fig. 1** dargestellte Konfiguration der Lotdepoterzeugungsvorrichtung 10 zeigt die oberhalb der Trägerplattform 12 angeordnete Handhabungseinrichtung 11 in einer Zustellphase, in der über eine Zustellbewegung 25 des Mundstücks 17 das Halbleiterbauelement 19 gegen die Trägerplattform 12 verfahren wird. Bereits während dieser Zustellbewegung kann, wie in **Fig. 1** dargestellt, eine rückwärtige Beaufschlagung des Halbleiterbauelements 19 mit Energie erfolgen, die zu einer Erwärmung des Halbleiterbauelements 19 führt. Im vorliegenden Fall handelt es sich bei der in das Halbleiterbauelement 19 eingebrachten Energie um Laserenergie 33.

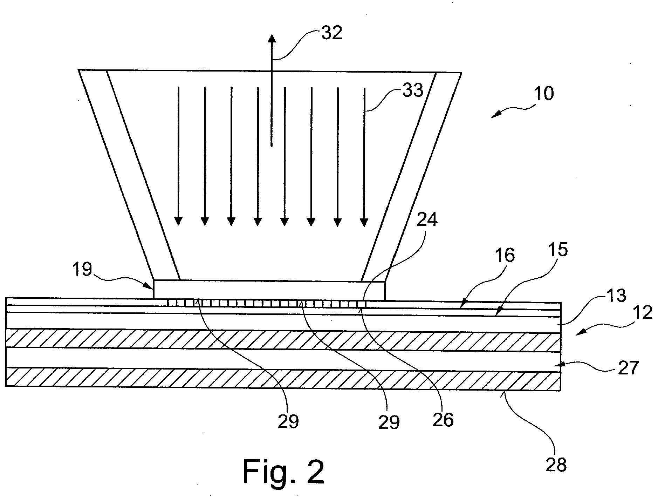

**Fig. 2** zeigt die Lotdepoterzeugungsvorrichtung 10 in einer der Zustellphase nachfolgenden Benetzungsphase, in der sich Benetzungsoberflächen 26 der Kontaktmetallisierungen 24 in Berührungskontakt mit der Lotmaterialschicht 15 befinden und dabei durch die Flussmittelschicht 16 von der Umgebung abgeschirmt sind.

Wenn nicht bereits, wie in **Fig. 1** dargestellt, eine rückwärtige Energiebeaufschlagung des Halbleiterbauelements 19 mit Laserenergie 33 während der Zustellphase erfolgt, erfolgt spätestens in der in **Fig. 2** dargestellten Benetzungsphase eine rückwärtige Energiebeaufschlagung, derart, dass vermittels Wärmeleitung durch das Halbleiterbauelement 19 eine Aufheizung der Kontaktmetallisierungen 24 erfolgt. Gleichzeitig mit der Aufheizung der Kontaktmetallisierungen 24 erfolgt eine Kühlung der auf dem Lotmaterialträger 13 ausgebildeten Lotmaterialschicht 15 vermittels einer entsprechenden Temperierung der Trägerplattform 12 über eine im vorliegenden Fall in der Trägerplattform 12 ausgebildete Temperiereinrichtung 27. Zur Ausbildung der Temperiereinrichtung 27 ist in der Trägerplattform 12 ein hier nicht näher dargestellter Kühlmitteldurchfluss ausgebildet. Abweichend hiervon ist es auch in einem Beispiel, das zum Verständnis der Erfindung beiträgt, möglich, eine separat von der Trägerplattform 12 ausgebildete Temperiereinrichtung vorzusehen, die beispielsweise durch eine Kühlplatte ausgebildet sein kann, die mit einer Unterseite 28 der Trägerplattform 12 kontaktiert wird.

Unabhängig davon, auf welche Art und Weise eine Kühlung der auf dem Lotmaterialträger 13 angeordneten Lotmaterialschicht 15 erfolgt, bewirkt die während der Beheizung des Halbleiterbauelements 19 erfolgende Kühlung der Lotmaterialschicht 15, dass es lediglich in den Kontaktbereichen zwischen den Benetzungsoberflächen 26 und der Lotmaterialschicht 15 zu einem Aufschmelzen der Lotmaterialschicht 15 kommt und in Bereichen der Lotmaterialschicht 15, die gegenüberliegend von Kontaktmetallisierungszwischenräumen 29 angeordnet sind, ein Aufschmelzen nicht erfolgt oder es zumindest zu einer im Vergleich zu den den Benetzungsoberflächen 26 gegenüberliegenden Bereichen verringerten Verflüssigung der Lotmaterialschicht 15 kommt.

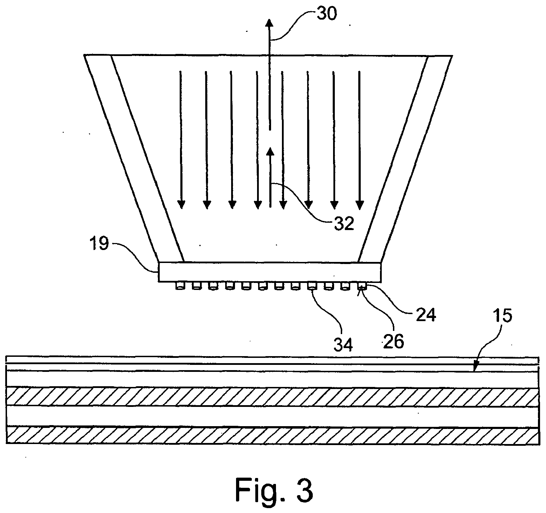

**Fig. 3** zeigt eine der in **Fig. 2** dargestellten Benetzungsphase nachfolgende Erstarrungsphase, in der durch eine Rückstellbewegung 30 die Kontaktmetallisierungen 24 außer Kontakt mit der Lotmaterialschicht 15 gebracht sind und auf den Benetzungsoberflächen 26 der Kontaktmetallisierungen 24 infolge der Benetzung entstandene Lotmaterialmenisken Lotdepots 34 ausbilden. Je nachdem, ob in der in **Fig. 3** dargestellten Konfiguration der Lotdepoterzeugungsvorrichtung 10 weiterhin eine Beheizung des Halbleiterbauelements 19 erfolgt oder nicht, kann der flüssige Aggregatzustand der Lotdepots 34 beibehalten werden, oder die Lotdepots können in einen festen Zustand überführt werden.

## Patentansprüche

1. Verfahren zur Ausbildung von Lotdepots (34) auf erhöhten Kontaktmetallisierungen (24) von Anschlussflächen (23) eines Substrats (19), bei dem Benetzungsoberflächen (26) der Kontaktmetallisierungen (24) in Berührungskontakt mit einer auf einem Lotmaterialträger (13) angeordneten Lotmaterialschicht (15) gebracht werden, zumindest während der Dauer des Berührungskontakts eine Beheizung des Substrats (19) und dessen Kontaktmetallisierungen (24) und gleichzeitig eine Temperierung der Lotmaterialschicht (15) erfolgt,
und nachfolgend eine Trennung des Berührungskontakts zwischen den mit Lotmaterial (34) benetzten Kontaktmetallisierungen (24) und der Lotmaterialschicht (15) erfolgt,
wobei die Temperierung der Lotmaterialschicht (15) während der Aufheizung der Kontaktmetallisierungen (24) als Kühlung der auf dem Lotmaterialträger (13) ausgebildeten Lotmaterialschicht (15) vermittels einer entsprechenden Temperierung einer den Lotmaterialträger (13) aufnehmenden temperierbaren Trägerplattform (12) über eine in der Trägerplattform (12) als Kühlmitteldurchfluss ausgebildete Temperiereinrichtung (27) erfolgt, wodurch es lediglich in diskreten, lokal begrenzten, durch die Benetzungsoberflächen (26) der Kontaktmetallisierungen (24) definierten Bereichen der Lotmaterialschicht (15) zu einem Aufschmelzen mit entsprechender Benetzung der Benetzungsoberflächen (26) kommt und zwischen den Benetzungsoberflächen (26) der Kontaktmetallisierungen (24) Bereiche in der Lotmaterialschicht (15) verbleiben, welche abweichend von den Bereichen der Lotmaterialschicht (15), die den Benetzungsoberflächen (26) der Kontaktmetallisierungen (24) gegenüberliegen, nicht aufgeschmolzen sind, womit verhindert wird, dass es bei einer Trennung des Berührungskontakts zwischen den Benetzungsoberflächen (26) der Kontaktmetallisierungen (24) und der Lotmaterialschicht (15) aufgrund der Oberflächenspannung von aufgeschmolzenem Lotmaterial zur Ausbildung von Kontaktbrücken zwischen benachbarten Kontaktmetallisierungen (24) kommt, wobei durch das diskrete bzw. partielle Aufschmelzen der Lotmaterialschicht (15) die aufgeschmolzenen Bereiche aus der Lotmaterialschicht (15) aufgrund der Benetzungskräfte herausgelöst werden und die nicht aufgeschmolzenen Bereiche der Lotmaterialschicht (15) auf dem Lotmaterialschichtträger (13) verbleiben.

2. Verfahren nach Anspruch 1,
wobei während der Ausbildung des Berührungskontakts mit der Lotmaterialschicht (15) zumindest die Kontaktmetallisierungen (24) in einer Schutzmediumatmosphäre angeordnet sind.

3. Verfahren nach Anspruch 2,
wobei die Ausbildung der Schutzmediumatmosphäre durch den Auftrag einer Flussmittelschicht (16) auf die Lotmaterialschicht (15) erfolgt.

4. Verfahren nach einem der vorangehenden Ansprüche,
wobei die Kontaktierung der Kontaktmetallisierungen (24) mit der Lotmaterialschicht (15) und die Trennung der Kontaktmetallisierungen (24) von der Lotmaterialschicht (15) vermittels einer Zustell- bzw. Rückstellbewegung des Substrats (19) erfolgt.

5. Verfahren nach einem der vorangehenden Ansprüche,
wobei das Substrat (19) als Halbleiterbauelement ausgebildet ist.

## Claims

1. A method for forming solder deposits (34) on elevated contact metallisations (24) of terminal faces (23) of a substrate (19), in which wetting surfaces (26) of the contact metallisations (24) are brought into physical contact with a solder material layer (15) arranged on a solder material carrier (13), at least for the duration of the physical contact a heating of the substrate and of its contact metallisations (24) and simultaneously a tempering of the solder material layer (15) is performed,
and subsequently a separation of the physical contact between the contact metallisations (24) wetted with solder material (34) and the solder material layer (15) is performed,
wherein the tempering of the solder material layer (15) during the heating of the contact metallisations (24) is performed as cooling of the solder material layer (15) formed on the solder material carrier (13) by means of correspondingly tempering a carrier platform (12) accommodating the solder material carrier (13) via a tempering device (27) formed in the carrier platform (12) as a coolant line, wherein melting together with a corresponding wetting of the wetting surfaces (26) only occurs in isolated, local areas of the solder material layer (15) that are defined by the wetting surfaces (26) of the contact metallisations (24), and between the wetting surfaces (26) of the contact metallisations (24) areas remain in the solder material layer (15) which are not molten in contrast to the areas of the solder material layer (15) which are positioned opposite of the wetting surfaces (26) of the contact metallisations (24),
wherein it is precluded that a forming of contact bridges between neighbouring contact metallisations (24) occurs in case of a separation of the physical contact between the wetting surfaces (26) of the contact metallisations (24) and the solder material layer (15) due to the surface tension of molten solder material, wherein by the isolated or partial melting of the solder material layer (15) the molten areas are released from the solder material layer (15) due to the wetting forces and the non-molten areas of the solder material layer (15) remain on the solder material layer carrier (13).

2. The method according to claim 1,
wherein during the formation of the physical contact with the solder material layer (15) at least the contact metallisations (24) are disposed in a protective medium atmosphere.

3. The method according to claim 2,
wherein the formation of the protective medium atmosphere is effected by the application of a flux layer (16) onto the solder material layer (15).

4. The method according to any of the preceding claims,
wherein the contacting of the contact metallisations (24) with the solder material layer (15) and the separation of the contact metallisations (24) from the solder material layer (15) are effected by an approach motion and a retreat motion of the substrate (19), respectively.

5. The method according to any of the preceding claims,
wherein the substrate (19) is formed as a semiconductor component.

## Revendications

1. Procédé pour former des dépôts de brasure (34) sur des métallisations de contact saillantes (24) de faces de raccordement (23) d'un substrat (19), dans lequel des faces de mouillage (26) des métallisations de contact (24) sont mises en contact physique avec une couche de matériau de brasure (15) disposée sur un support de matériau de brasure (13), le substrat (19) et ses métallisations de contact (24) sont chauffés au moins pour la durée du contact physique et la température de la couche de matériau de brasure (15) est contrôlée simultanément,
et ensuite le contact physique entre les métallisations de contact (24) mouillées avec du matériau de brasure (34) et la couche de matériau de brasure (15) est séparé,
dans lequel la température de la couche de matériau de brasure (15) est contrôlée pendant le chauffage des métallisations de contact (24) sous la forme d'un refroidissement de la couche de matériau de brasure (15) formée sur le support de matériau de brasure (13) en contrôlant de manière correspondante la température d'une plateforme de support (12), dont la température peut être contrôlée et qui loge le support de matériau de brasure (13), à l'aide d'un dispositif de contrôle de température (27) réalisé comme ligne de réfrigérant dans la plateforme de support (12), ce qui entraine une fusion, de même qu'un mouillage correspondant, des faces de mouillage (26) seulement dans des zones discrètes et limitées localement de la couche de matériau de brasure (15) qui sont définies par les faces de mouillage (26) des métallisations de contact (24), et des zones qui ne sont pas fondues contrairement aux zones de la couche de matériau de brasure (15) qui font face aux faces de mouillage (26) des métallisations de contact (24) restent dans la couche de matériau de brasure (15) entre les faces de mouillage (26) des métallisations de contact (24), ce qui empêche que des ponts de contact se forment entre des métallisations de contact (24) adjacentes lors d'une séparation du contact physique entre les faces de mouillage (26) des métallisations de contact (24) et la couche de matériau de brasure (15) à cause de la tension de surface du matériau de brasure fondu, dans lequel la fusion discrète ou partielle de la couche de matériau de brasure (15) permet aux zones fondues d'être libérées de la couche de matériau de brasure (15) à cause des forces de mouillage et aux zones non fondues de la couche de matériau de brasure (15) de rester sur le support de couche de matériau de brasure (13).

2. Procédé selon la revendication 1,
dans lequel au moins les métallisations de contact (24) sont disposées dans une atmosphère de milieu de protection pendant la formation du contact physique avec la couche de matériau de brasure (15).

3. Procédé selon la revendication 2,
dans lequel l'atmosphère de milieu de protection est formée en appliquant une couche de flux (16) sur la couche de matériau de brasure (15).

4. Procédé selon l'une quelconque des revendications précédentes, dans lequel les métallisations de contact (24) sont mises en contact avec la couche de matériau de brasure (15) et les métallisations de contact (24) sont séparées de la couche de matériau de brasure (15) respectivement par un mouvement d'avance et un mouvement de retour du substrat (19).

5. Procédé selon l'une quelconque des revendications précédentes, dans lequel le substrat (19) est réalisé comme un dispositif semiconducteur.
